# EUROPEAN PATENT APPLICATION

(11) **EP 4 766 145 A1**
(43) Date of publication of application: **24.06.2026**
(21) Application number: 25221664.3
(22) Date of filing: 09.12.2025
(51) Int. Cl.: H10W 72/00, H10P 72/00, H10P 72/50

(54) **BONDING APPARATUS, BONDING METHOD AND ARTICLE MANUFACTURING METHOD**

(30) Priority: 18.12.2024 JP 2024221985
(71) Applicant: CANON KABUSHIKI KAISHA, Ohta-ku Tokyo 146-8501 (JP)
(72) Inventor: TAKAHASHI, Kai, Tokyo, 146-8501 (JP); KUBOTA, Yusuke, Tokyo, 146-8501 (JP)
(74) Representative: TBK

(57) **Abstract**

A bonding apparatus that bonds a first object and a second object, including a stage including a relay unit configured to hold the first object, and a holding unit configured to hold the second object, a head configured to hold the first object, a driving unit configured to drive at least one of the stage and the head to bond the first object and the second object, a first camera configured to capture an object on the stage, and a control unit configured to align the first object held by the head and the second object held by the holding unit based on results of capturing, by the first camera, the first object held by the relay unit and the second object held by the holding unit.

## Description

### TECHNICAL FIELD

The present disclosure relates to a bonding apparatus, a bonding method and an article manufacturing method.

### BACKGROUND

A bonding apparatus is, for example, an apparatus (semiconductor manufacturing apparatus) that is used in a semiconductor manufacturing process, and bonds a chip as a bonding object to a substrate as a bonding target object. There are two types of bonding (bonding methods) between a chip and a substrate: face-up bonding, in which the chip in a face-up state is bonded to the substrate, and face-down bonding, in which the chip in a face-down state is bonded to the substrate. These bonding methods are selectively used depending on the types of chip and substrate, the application purpose of the semiconductor device after bonding, and the like.

Since both the face-up bonding method and the face-down bonding method have clear application purposes, a bonding apparatus with only one of these bonding methods is limited in the semiconductor devices that can be produced (application purposes thereof). Therefore, Japanese Patent Laid-Open Nos. 2017-183378 and 2002-330000 propose bonding apparatuses capable of performing both face-up bonding and face-down bonding.

In recent years, in the semiconductor industry, a technique has been attracting attention in which different dies called chiplets are bonded with high-density I/O, thereby implementing a high-performance semiconductor device in a single package. In the chiplet technique, the interval between high-density I/O connection pads arranged on the respective dies is about 1 micrometer. Accordingly, the bonding accuracy (positional accuracy) of about 100 nanometers is required. Since the bonding accuracy of a currently available bonding apparatus is about 2 micrometers, there is a demand for improvement in bonding accuracy.

To achieve highly accurate bonding in a bonding apparatus, particle countermeasure for preventing foreign substances from being caught at the bonding surface, bonding by intermolecular bond instead of an adhesive agent, and the like are some of the methods that can be used, but accurate alignment between the chip and the substrate is particularly important. Therefore, the patterns or marks formed in the chip surface and the substrate surface are observed using a camera or the like, and the obtained observation results are fed back to a control system that controls the units holding the chip and the substrate to align the chip and the substrate.

For example, in face-down bonding, a bonding head holds the back surface (the surface opposite to the pattern surface where the pattern or mark of the chip is formed) of the chip. Accordingly, the chip held by the bonding head can be observed and bonded to the substrate intact. On the other hand, in face-up bonding, the bonding head holds the pattern surface of the chip, so the chip held by the bonding head cannot be directly observed. Accordingly, the pattern or mark of the chip is observed before the chip is passed to the bonding head, and the chip is bonded to the substrate based on the observation result. However, when the chip is passed to the bonding head after the observation, the relative position between the chip and the substrate may be shifted. In this manner, it is generally more difficult to achieve highly accurate alignment in face-up bonding than in face-down bonding.

### SUMMARY

Conventional techniques can perform both face-up bonding and face-down bonding, but it cannot be said that highly accurate alignment between a chip and a substrate is achieved in face-up bonding, and there is a risk of a bonding error between the chip and the substrate.

For example, Japanese Patent Laid-Open No. 2017-183378 discloses a bonding apparatus including a pickup head that picks up a chip, an intermediate stage that holds and relays the chip, a bonding head that bonds the chip, and a stage that holds a substrate. In face-up bonding, this bonding apparatus observes the chip held by the intermediate stage, and then passes the chip to the bonding head for bonding to the substrate. However, since the intermediate stage is formed separately from the stage for holding the substrate and includes a drive shaft, a chip conveyance error occurs depending on the driving accuracy of the intermediate stage. This is because, since the relative position between the substrate held by the stage and the chip held by the intermediate stage is not sufficiently ensured, the driving error of the stage is added to the driving error of the intermediate stage, thereby causing a chip conveyance error and ultimately leading to a bonding error.

Japanese Patent Laid-Open No. 2002-330000 discloses a technique in which an intermediate stage has the same configuration as a stage, the relative position between the chip held by the intermediate stage and the substrate held by the stage is ensured, and the chip is passed from the intermediate stage to a bonding head and bonded to the substrate. However, in this technique, since a camera for observing the chip includes a drive shaft, a bonding error between the chip and the substrate occurs due to the influence of the driving accuracy of the camera, as described in relation to Japanese Patent Laid-Open No. 2017-183378.

The present disclosure provides a technique advantageous in bonding the first object and the second object with high accuracy.

The present disclosure in its first aspect provides a bonding apparatus as specified in claim 1. Optional features are specified in claims 2 to 13.

The present disclosure in its second aspect provides a bonding method as specified in claim 14.

The present disclosure in its third aspect provides an article manufacturing method as specified in claim 15.

Features of the present disclosure will become apparent from the following description of embodiments with reference to the attached drawings. The following description of embodiments is described by way of example.

### BRIEF DESCRIPTION OF THE DRAWINGS

Fig. 1 is a schematic view illustrating configurations of a bonding apparatus according to an aspect of the present disclosure.
Fig. 2 is a schematic view illustrating configurations of a bonding apparatus according to an aspect of the present disclosure.
Fig. 3 is a flowchart for explaining a bonding operation for face-up bonding.
Fig. 4 is a flowchart for explaining a bonding operation for face-down bonding.
Figs. 5A to 5C are views for explaining a technique for improving the bonding accuracy between a bonding object and a bonding target object.
Fig. 6 is a flowchart for explaining a bonding operation for face-up bonding.
Fig. 7 is a flowchart for explaining a bonding operation for face-down bonding.
Figs. 8A and 8B are views for explaining a technique for improving the bonding accuracy between a bonding object and a bonding target object.

### DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

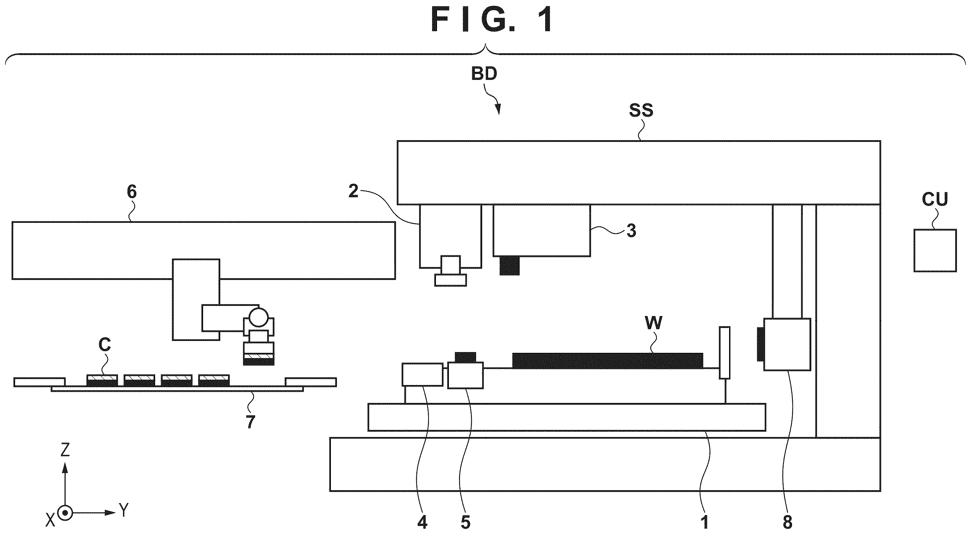

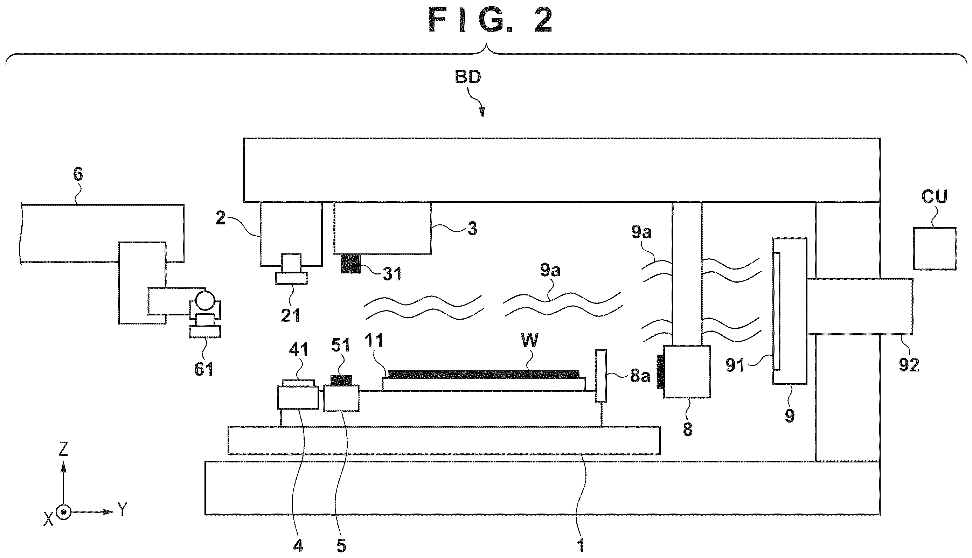

Figs. 1 and 2 are views schematically illustrating configurations of a bonding apparatus BD according to an aspect of the present disclosure. Fig. 1 illustrates configurations of the entire bonding apparatus BD, and Fig. 2 illustrates configurations around a stage 1 of the bonding apparatus BD. The bonding apparatus BD bonds bonding objects C (first objects) such as chips separated by dicing a wafer to a bonding target object W (second object) such as a substrate (wafer). In this embodiment, the bonding apparatus BD is provided with a dicing frame where a plurality of bonding objects C are adhered to (arrayed on) a dicing tape, or a tray on which a plurality of bonding objects C are arranged (arrayed).

In this specification, as illustrated in respective drawings, directions are indicated on an XYZ coordinate system. Typically, an X-Y plane is a plane parallel to the horizontal plane, and a Z-axis is an axis parallel to the vertical direction. X-, Y-, and Z-axes are illustrated as examples of directions orthogonal to each other or crossing each other.

As illustrated in Figs. 1 and 2, the bonding apparatus BD includes the stage 1, a bonding unit 2, a first camera 3, a relay unit 4, a second camera 5, a pickup unit 6, a supply unit 7, a measurement unit 8, a blowout unit 9, a supporting structure SS, and a control unit CU.

The supply unit 7 is a unit for temporarily holding (storing) the dicing frame or tray loaded into the bonding apparatus BD, and supplying the bonding objects C arrayed on the dicing frame or tray into the apparatus.

The pickup unit 6 includes, for example, a pickup head 61. The pickup unit 6 sucks and holds, by the pickup head 61, the bonding object C to be bonded to the bonding target object W among the bonding objects C held by the supply unit 7, and conveys (passes) it to the relay unit 4 or the bonding unit 2. The pickup head 61 may include a flip shaft that rotates (reverses) the bonding object C by 180°.

The bonding unit 2 is a unit for performing a bonding operation of bonding the bonding object C to the bonding target object W. The bonding unit 2 includes a bonding head 21 that holds, via a chuck, the bonding object C passed (received) from the pickup unit 6 or the relay unit 4. The bonding unit 2, more specifically, the bonding head 21 may not include a drive shaft, or may include a drive shaft concerning the Z-axis and the θZ-axis which is a rotational axis about the Z-axis.

The stage 1 is a stage that includes a chuck 11 (holding unit) for sucking and holding the bonding target object W, and the relay unit 4 (to be described later), and is configured to be movable. The stage 1 includes drive shafts concerning six axes at maximum, more specifically, drive shafts concerning the X-, Y-, and Z-axes, and θX-, θY-, and θZ-axes which are rotational axes about the respective axes. The driving mechanism including these drive shafts is preferably a driving mechanism that is powered by a linear motor or a voice coil motor and guided by an air bearing.

The measurement unit 8 is a unit that measures (captures) the position of the stage 1. The measurement unit 8 measures the position of the stage 1 by, for example, detecting a position measurement target 8a provided on the stage 1. To achieve highly accurate position control of the stage 1, the measurement unit 8 preferably includes an interferometer or an encoder. When the measurement unit 8 includes an interferometer, the position measurement target 8a is a bar mirror. When the measurement unit 8 includes an encoder, the position measurement target 8a is a scale. Note that when the measurement unit 8 includes an encoder, an encoder head may be provided on the stage 1.

The relay unit 4 is provided in connection with the stage 1 (as a part of the stage 1). The relay unit 4 moves together with the chuck 11 via the stage 1 in a state in which the relative position with respect to the chuck 11 is ensured. The relay unit 4 includes a relay chuck 41 that sucks and holds the bonding object C before being held by the bonding unit 2, more specifically, the bonding head 21, and is embodied as a relay table that fixes the position of the bonding object C. The relay unit 4 is mainly used in face-up bonding of the bonding object C to the bonding target object W. The relay unit 4 receives the bonding object C from the pickup unit 6, and passes the bonding object C to the bonding unit 2.

Here, face-up bonding is a bonding method for bonding the bonding object C to the bonding target object W in a state in which the pattern surface (circuit surface) of the bonding object C formed with the pattern faces upward. Another bonding method for bonding the bonding object C to the bonding target object W is face-down bonding of bonding the bonding object C to the bonding target object W in a state in which the pattern surface of the bonding object C faces downward.

The first camera 3 captures (observes), via a lens 31, objects on the stage, more specifically, the bonding target object W held by the chuck 11 and the bonding object C held by the relay unit 4. The first camera 3 includes no drive shaft, and is supported by the supporting structure SS whose relative position with respect to the stage 1 is ensured. In this manner, the supporting structure SS fixes the position of the first camera 3 in the X and Y directions (the first and second directions crossing in the X-Y plane as the horizontal plane).

The second camera 5 is provided in connection with the stage 1 (as a part of the stage 1), and captures (observes), via a lens 51, the bonding object C held by the bonding head 21. By moving the stage 1, the second camera 5 can be moved to a position in the field of view of the first camera 3 supported by the supporting structure SS. In a state in which the second camera 5 is located at a position in the field of view of the first camera 3, the first camera 3 and the second camera 5 can capture each other or either one.

The blowout unit 9 is a unit that blows out, through a filter 91, clean air 9a managed (adjusted) at a specific temperature set in advance in one direction from upstream (the right side in Fig. 2) to downstream (the left side in Fig. 2) of the bonding apparatus BD. By blowing out the air 9a from the blowout unit 9, it is possible to maintain the space around the stage 1 at a constant temperature, and maintain the space around the stage 1 in a clean state. The position where the bonding object C is passed between the units is set downstream of the position where the chuck 11 of the stage 1 holds the bonding target object W (the bonding position where the bonding object C is bonded to the bonding target object W) with respect to the blowout unit 9 (the flow of the air 9a). In this embodiment, the relay unit 4 and the bonding unit 2 that hold the bonding object C are located on the downstream side of the chuck 11 (stage 1) that holds the bonding target object W. In other words, the chuck 11 is provided upstream of the relay unit 4 with respect to the blowout unit 9.

The control unit CU is formed from a computer (information processing apparatus) that includes, for example, a CPU, a memory, and the like. The control unit CU operates the bonding apparatus BD by comprehensively controlling the respective units of the bonding apparatus BD in accordance with a program stored in a storage unit. For example, the control unit CU achieves highly accurate position control of the stage 1 based on the measurement result of the measurement unit 8. In addition, the control unit CU moves the stage 1 to a predetermined position based on the result of capturing by the first camera 3 or the second camera 5 while controlling the stage 1 based on the measurement result of the measurement unit 8.

As the bonding method for bonding the bonding object C to the bonding target object W, the bonding apparatus BD can perform both face-up bonding and face-down bonding. In this embodiment, in order to perform both face-up bonding and face-down bonding, the control unit CU acquires bonding object information including information about the kind (type) of the bonding object C such as the size, shape, and thickness of the bonding object C. Based on the bonding object information, the control unit CU decides (selects) whether to perform face-up bonding of the bonding object C to the bonding target object W or perform face-down bonding of the bonding object C to the bonding target object W. Note that the bonding object information may be acquired from a recipe or the like set (provided) in the bonding apparatus BD, or may be acquired from input information which is input by the user via a user interface of the bonding apparatus BD or the like.

Hereinafter, in each embodiment, as an operation of the bonding apparatus BD, a bonding operation of bonding the bonding object C to the bonding target object W will be described specifically. The bonding operation is performed by the control unit CU comprehensively controlling the respective units of the bonding apparatus BD.

### <First Embodiment>

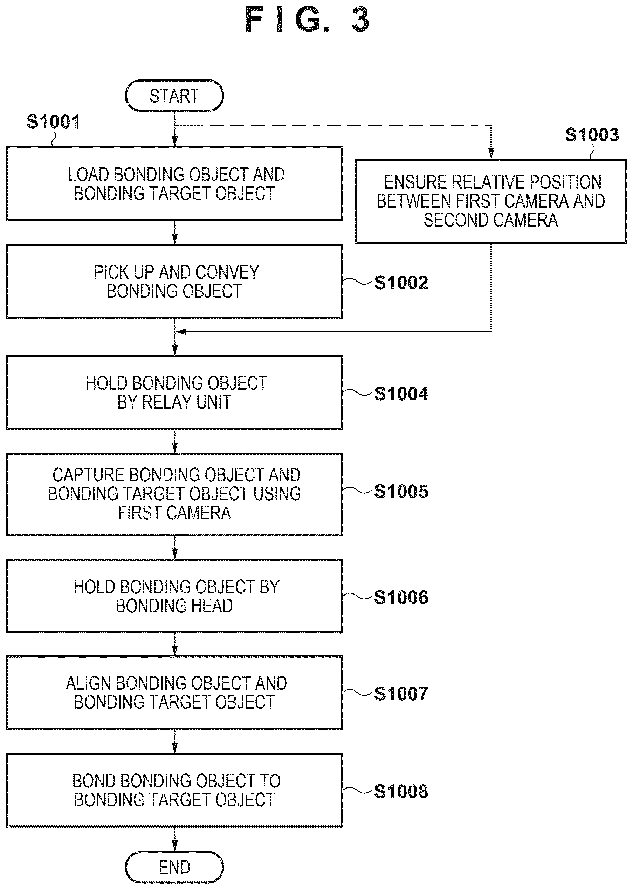

With reference to Fig. 3, a bonding operation for face-up bonding will be described. In step S1001, a bonding object C and a bonding target object W are loaded into a bonding apparatus BD. The bonding object C is loaded into the bonding apparatus BD in a state in which the pattern surface faces a pickup unit 6 (pickup head 61), that is, the pattern surface faces upward, and temporarily held by a supply unit 7. In face-up bonding, the back surface (the surface on the opposite side of the pattern surface) of the bonding object C is bonded to the bonding target object W. Therefore, an adhesive agent may be applied to the back surface of the bonding object C loaded into the bonding apparatus BD. Alternatively, when bonding by intermolecular bond is performed, the back surface of the bonding object C may be activated. Note that if a foreign substance adheres to the back surface of the bonding object C, this causes a bonding failure between the bonding object C and the bonding target object W. To prevent this, the internal space of the bonding apparatus BD is maintained at a cleanliness of about class 1. In order to maintain the high cleanliness, the dicing frame or tray on which a plurality of bonding objects C are arrayed may be accommodated in an accommodating case with high airtightness and high cleanliness and loaded into the bonding apparatus BD. In order to achieve higher cleanliness, the dicing frame or tray may be cleaned in the bonding apparatus. On the other hand, the bonding target object W is loaded into the bonding apparatus BD in a state in which the bonding target surface (the surface to be bonded with the bonding object C) faces a bonding unit 2 (bonding head 21), that is, the bonding target surface faces upward, and held by a chuck 11 of a stage 1.

In step S1002, the pickup unit 6 picks up the bonding object C from the supply unit 7, and conveys the bonding object C to a relay unit 4. More specifically, among the bonding objects C held by the supply unit 7, the bonding object C to be bonded to the bonding target object W is sucked and held by the pickup head 61, and conveyed (passed) to the relay unit 4. At this time, since the pickup head 61 holds the pattern surface of the bonding object C, the end portion of the pickup head 61, that is, the portion for holding the bonding object C is preferably cleaned in advance to suppress adhesion of a foreign substance to the pattern surface of the bonding object C.

In step S1003, the relative position between a first camera 3 and a second camera 5 is ensured. More specifically, in a state in which the stage 1 is moved to locate the second camera 5 at a position in the field of view of the first camera 3, the first camera 3 and the second camera 5 capture (observe) each other or either one. For the first camera 3 and the second camera 5 to observe each other or either one, a target to be observed is required. Therefore, in a case where the first camera 3 and the second camera 5 observe each other, each of the first camera 3 and the second camera 5 is provided with the target. In a case where the first camera 3 observes the second camera 5, the second camera 5 is provided with the target. In a case where the second camera 5 observes the first camera 3, the first camera 3 is provided with the target. The target is provided as an easily identifiable mark or pattern on, for example, the lens or housing of the camera. In this embodiment, as described above, the second camera 5 is formed integrally with the stage 1. With this, the relative position between the second camera 5 and the bonding target object W held by the chuck 11 of the stage 1 is ensured. Accordingly, when the first camera 3 and the second camera 5 capture each other or either one, the relative position between the first camera 3 and the second camera 5 is ensured. This is because the first camera 3 can observe the bonding target object W held by the chuck 11, and the second camera 5 can observe the bonding object C held by the bonding head 21. Hence, the relative position between the bonding target object W observed (captured) by the first camera 3 and the bonding object C observed (captured) by the second camera 5 is ensured. Note that step S1003 only needs to be executed before step S1004. For example, step S1003 may be executed in parallel with step S1001 or S1002.

In step S1004, the relay unit 4 holds the bonding object C conveyed by the pickup unit 6. More specifically, a relay chuck 41 receives the bonding object C passed from the pickup head 61, and the relay chuck 41 sucks and holds the bonding object C. At this time, the relay chuck 41 holds the back surface of the bonding object C. Since the back surface of the bonding object C is the surface applied with the adhesive agent or the activated surface, the relay chuck 41 preferably holds the bonding object C with higher cleanliness than the pickup head 61. Therefore, in addition to blowing out air 9a from a blowout unit 9 to maintain the clean space around the relay chuck 41, the portion (holding surface) of the relay chuck 41 for holding the bonding object C is preferably cleaned in advance, similar to the pickup head 61. In this embodiment, as described above, the relay unit 4 is formed integrally with the stage 1. This is so to ensure the relative position between the bonding object C held by the relay unit 4 and the bonding target object W held by the chuck 11 of the stage 1. Even if the stage 1 moves so that the position of the bonding target object W held by the chuck 11 changes, since the relay unit 4 moves together with the stage 1, the position of the bonding object C held by the relay unit 4 changes similarly to the position of the bonding target object W. Note that if the relay unit 4 is formed integrally with the stage 1 but includes its own drive shaft, the relative position between the bonding object C held by the relay unit 4 and the bonding target object W held by the chuck 11 changes. Hence, it is preferable that the relay unit 4 does not include its own drive shaft. In this embodiment, the relay unit 4 includes no drive shaft.

In step S1005, the first camera 3 captures each of the bonding object C held by the relay unit 4 and the bonding target object W held by the chuck 11. Each of the pattern surface of the bonding object C and the bonding target surface of the bonding target object W is provided with a pattern or mark that the first camera 3 can easily identify. When the first camera 3 captures the pattern or mark, positional information about the relative position between the bonding object C and the bonding target object W is obtained. In this embodiment, the first camera 3 is supported by a supporting structure SS whose relative position with respect to the stage 1 is ensured, and includes no drive shaft, that is, is fixed in the X and Y directions. Therefore, it is necessary to locate each of the bonding object C and the bonding target object W at a position in the field of view of the first camera 3. At this time, since the relay unit 4 for holding the bonding object C is formed integrally with the stage 1, by moving the stage 1, it is possible to change the position of each of the bonding object C and the bonding target object W with respect to the first camera 3 while ensuring the relative position between the bonding object C and the bonding target object W. Thus, the relative position between the bonding object C and the bonding target object W to be captured by the first camera 3 is ensured.

In step S1006, the bonding unit 2 holds the bonding object C held by the relay unit 4. More specifically, the bonding head 21 receives the bonding object C passed from the relay unit 4, and the bonding object C is held by the bonding head 21. At this time, the bonding head 21 holds the pattern surface of the bonding object C. The bonding head 21 has not only a function of holding the bonding object C but also a function of bonding the bonding object C to the bonding target object W held by the chuck 11 of the stage 1. Since the bonding head 21 directly influences the bonding accuracy between the bonding object C and the bonding target object W, it needs to handle the bonding object C with high accuracy. Therefore, the bonding head 21 preferably does not include more drive shafts than necessary. In this embodiment, the bonding head 21 includes only the drive shaft concerning the Z-axis and the θZ-axis. The driving mechanism including the drive shaft is preferably a driving mechanism that is powered by a linear motor or a voice coil motor and guided by an air bearing. Similar to the first camera 3, the bonding head 21 (bonding unit 2) is preferably supported by the supporting structure SS whose relative position with respect to the stage 1 is ensured. In order to hold the bonding object C while maintaining the cleanliness, the portion of the bonding head 21 for holding the bonding object C is preferably cleaned in advance, similar to the pickup head 61 and the relay chuck 41.

In step S1007, the bonding object C held by the bonding head 21 and the bonding target object W held by the chuck 11 of the stage 1 are aligned in the X and Y directions. Alignment between the bonding object C and the bonding target object W is performed by moving the stage 1 based on the positional information obtained in step S1005 (results of capturing the bonding object C and the bonding target object W by the first camera 3). More specifically, in order to bond the bonding object C held by the bonding head 21 to the bonding portion of the bonding target object W held by the chuck 11 of the stage 1, the stage 1 is moved to the target position. At this time, the stage 1 is moved to the setting position set in advance. However, to achieve bonding with higher accuracy, there is a need to obtain the offset amount in advance. For example, the bonding object C and the bonding target object W are provided with marks that overlap when the bonding object C and the bonding target object W overlap each other. The more accurately these marks overlap, the more accurately the bonding object C and the bonding target object W are bonded. For this, in step S1005, the first camera 3 captures these marks. From the result of capturing, the positional shift of the mark provided on the bonding object C from the mark provided on the bonding target object W is obtained, and used as the offset amount. By setting the position obtained by adding the offset amount to the setting position as the target position to which the stage 1 is to be moved, it is possible to align the bonding object C and the bonding target object W with high accuracy, thereby achieving highly accurate alignment. Note that when moving the stage 1 to the target position, the position of the stage 1 is controlled based on the measurement result of a measurement unit 8.

In step S1008, the bonding object C held by the bonding head 21 is bonded to the bonding target object W (bonding portion thereof) held by the chuck 11 of the stage 1. When bonding the bonding object C to the bonding target object W, the bonding head 21 may be moved in the Z direction to bring the bonding object C close to the bonding target object W, or the stage 1 may be moved in the Z direction to bring the bonding target object W close to the bonding object C. Alternatively, each of the bonding head 21 and the stage 1 may be moved in the Z direction to bring the bonding object C and the bonding target object W close to each other. In this manner, in this embodiment, the driving mechanisms that respectively drive the stage 1 and the bonding head 21 function as a driving unit that drives at least one of the stage 1 and the bonding head 21 to bond the bonding object C and the bonding target object W. Note that until the bonding object C and the bonding target object W contact, the speed of moving the bonding object C or the bonding target object W is not limited, but immediately before the bonding object C and the bonding target object W contact, the speed of moving the bonding object C or the bonding target object W needs to be sufficiently reduced. Then, once the bonding object C and the bonding target object W contact completely, a load is applied to the bonding object C and the bonding target object W in accordance with the bonding load set in advance, thereby bonding the bonding object C to the bonding target object W.

As described above, according to this embodiment, in face-up bonding of the bonding object C to the bonding target object W, it is possible to align the bonding object C and the bonding target object W with high accuracy. Accordingly, it is possible to suppress the bonding error between the bonding object C and the bonding target object W, thereby achieving highly accurate bonding between the bonding object C and the bonding target object W.

### <Second Embodiment>

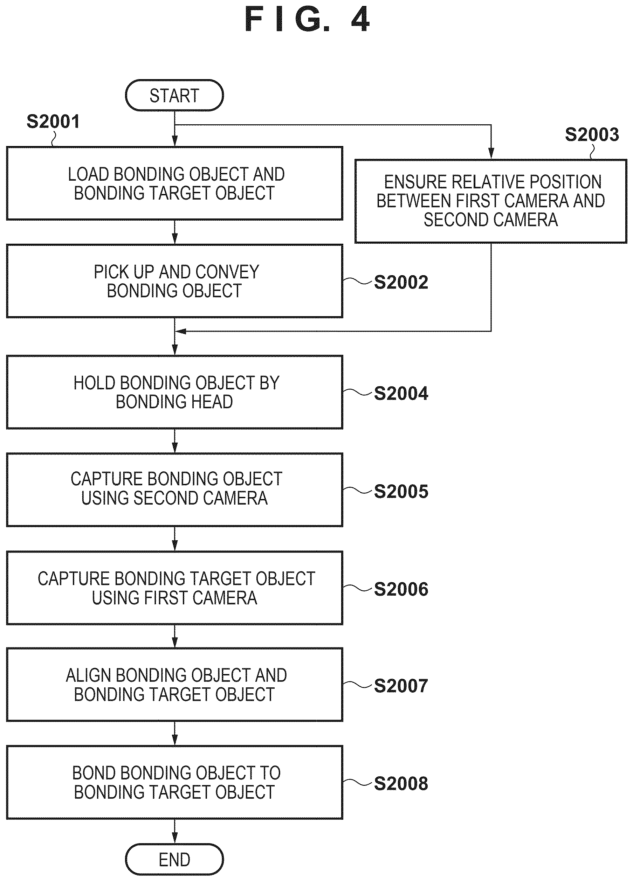

With reference to Fig. 4, a bonding operation for face-down bonding will be described. In step S2001, bonding objects C and a bonding target object W are loaded into a bonding apparatus BD. The bonding object C is loaded into the bonding apparatus BD in a state in which the pattern surface faces a pickup unit 6 (pickup head 61), that is, the pattern surface faces upward, and temporarily held by a supply unit 7. In face-downbonding, the pattern surface of the bonding object C is bonded to the bonding target object W. Therefore, an adhesive agent may be applied to the pattern surface of the bonding object C loaded into the bonding apparatus BD. Alternatively, when bonding by intermolecular bond is performed, the pattern surface of the bonding object C may be activated. Note that if a foreign substance adheres to the pattern surface of the bonding object C, this causes a bonding failure between the bonding object C and the bonding target object W. Therefore, the internal space of the bonding apparatus BD is maintained at a cleanliness of about class 1. In order to maintain the high cleanliness, the dicing frame or tray on which a plurality of bonding objects C are arrayed may be accommodated in an accommodating case with high airtightness and high cleanliness and loaded into the bonding apparatus BD. In order to achieve higher cleanliness, the dicing frame or tray may be cleaned in the bonding apparatus.

In step S2002, the pickup unit 6 picks up the bonding object C from the supply unit 7, and conveys the bonding object C to a bonding unit 2. More specifically, among the bonding objects C held by the supply unit 7, the bonding object C to be bonded to the bonding target object W is sucked and held by the pickup head 61, and conveyed (passed) to the bonding unit 2. At this time, since the pickup head 61 holds the pattern surface of the bonding object C, the end portion of the pickup head 61, that is, the portion for holding the bonding object C is preferably cleaned in advance to suppress adhesion of a foreign substance to the pattern surface of the bonding object C.

In step S2003, the relative position between a first camera 3 and a second camera 5 is ensured. The processing in step S2003 is similar to that in step S1003, so that a detailed description is omitted here. Note that step S2003 only needs to be executed before step S2004. For example, step S2003 may be executed in parallel with step S2001 or S2002.

In step S2004, the bonding unit 2 holds the bonding object C conveyed by the pickup unit 6. More specifically, a bonding head 21 receives the bonding object C passed from the pickup head 61, and the bonding object C is held by the bonding head 21. At this time, since the pickup head 61 holds the bonding object C with the pattern surface facing downward, it rotates the bonding object C by 180° via a flip shaft to make the pattern surface of the bonding object C face upward. Thus, the bonding head 21 can hold the bonding object C with the pattern surface facing upward. The bonding head 21 preferably holds the bonding object C with a higher cleanliness than the pickup head 61. Therefore, air 9a is blown out from a blowout unit 9 to maintain the clean space around the bonding head 21. Since the bonding head 21 holds the pattern surface of the bonding object C, the end portion of the bonding head 21, that is, the portion for holding the bonding object C is preferably cleaned in advance to suppress adhesion of a foreign substance to the pattern surface of the bonding object C.

In step S2005, the second camera 5 captures the bonding object C held by the bonding head 21. The pattern surface of the bonding object C is provided with a pattern or mark that the second camera 5 can easily identify. By capturing the pattern or mark by the second camera 5, positional information about the position of the bonding object C is obtained.

In step S2006, the first camera 3 captures the bonding target object W held by a chuck 11 of a stage 1. The bonding target object W is provided with a pattern or mark that the first camera 3 can easily identify. By capturing the pattern or mark by the first camera 3, positional information about the position of the bonding target object W is obtained. In this embodiment, the first camera 3 is supported by a supporting structure SS whose relative position with respect to the stage 1 is ensured, and includes no drive shaft, that is, is fixed in the X and Y directions. Therefore, it is necessary to locate the bonding target object W at a position in the field of view of the first camera 3. At this time, the positional information about the position of the bonding object C has been obtained by the second camera 5 (step S2005), and the second camera 5 is formed integrally with the stage 1. Accordingly, even if the stage 1 is moved to change the position of the bonding target object W, the position of the bonding target object W held by the chuck 11 and the positional information about the position of the bonding object C obtained in step S2005 are ensured. In other words, through steps S2005 and S2006, the relative position between the bonding object C captured by the second camera 5 and the bonding target object W captured by the first camera 3 is ensured.

In step S2007, the bonding object C held by the bonding head 21 and the bonding target object W held by the chuck 11 of the stage 1 are aligned in the X and Y directions. The processing in step S2007 is similar to that in step S1007, so that a detailed description is omitted here.

In step S2008, the bonding object C held by the bonding head 21 is bonded to the bonding target object W (bonding portion thereof) held by the chuck 11 of the stage 1. The processing in step S2008 is similar to that in step S1008, so that a detailed description is omitted here.

As described above, according to this embodiment, in face-down bonding of the bonding object C to the bonding target object W, it is possible to align the bonding object C and the bonding target object W with high accuracy. Accordingly, it is possible to suppress the bonding error between the bonding object C and the bonding target object W, thereby achieving highly accurate bonding between the bonding object C and the bonding target object W.

### <Third Embodiment>

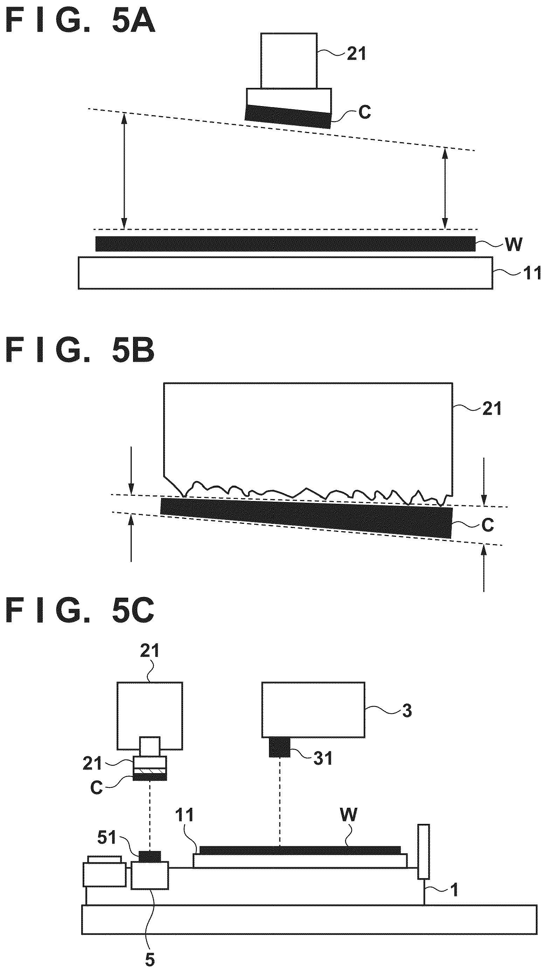

In this embodiment, a technique for improving the bonding accuracy between a bonding object C and a bonding target object W will be described with reference to Figs. 5A to 5C. This technique can be applied to both the face-up bonding described in the first embodiment and the face-down bonding described in the second embodiment.

When the bonding object C held by a bonding head 21 is made to face the bonding target object W held by a chuck 11 of a stage 1 before bonding the bonding object C and the bonding target object W, as illustrated in Fig. 5A, there may be a case where the degree of parallelization of the bonding object C with respect to the bonding target object W is not sufficiently ensured. In other words, the bonding object C may have an inclination with respect to the bonding target object W, or the bonding target object W may have an inclination with respect to the bonding object C.

Taking the bonding object C as an example, the bonding object C may have an inclination from an ideal state (ideal position) due to the influence of factors related to the bonding head 21 or factors related to the bonding object C. Here, factors related to the bonding head 21 include the attachment error and flatness of the portion of the bonding head 21 for holding the bonding object C, the holding distortion (suction distortion) of the bonding head 21 upon holding the bonding object C, and the like. Factors related to the bonding object C include the shape of the bonding object C, for example, a wedge component or the like. Note that the wedge component of the bonding object C means that the degree of parallelization between the pattern surface and the back surface of the bonding object C does not satisfy the required accuracy and the thickness of the bonding object C varies, as illustrated in Fig. 5B. The same applies to the bonding target object W.

In this manner, there may be a case where the bonding object C or the bonding target object W has an inclination, so the degree of parallelization of the bonding object C with respect to the bonding target object W is not sufficiently ensured. In this case, when the bonding object C and the bonding target object W contact, an unintended side or point of the bonding object C first contacts the bonding target object W, and this can cause a bonding failure such as pitching or voids.

To prevent this, in this embodiment, the inclination of the bonding object C held by the bonding head 21 and the inclination of the bonding target object W held by the chuck 11 of the stage 1 are measured, and the degree of parallelization of the bonding object C with respect to the bonding target object W is adjusted before bonding the bonding object C and the bonding target object W.

More specifically, as illustrated in Fig. 5C, the inclination of the bonding object C is measured from the contrast obtained by a second camera 5 capturing the bonding object C held by the bonding head 21. Similarly, the inclination of the bonding target object W is measured from the contrast obtained by a first camera 3 capturing the bonding target object W held by the chuck 11 of the stage 1. Note that the inclination of each of the bonding object C and the bonding target object W may be measured by using an interferometer, a laser displacement meter, or the like and irradiating a plurality of points of each of the bonding object C and the bonding target object W with a laser. Then, based on the inclinations (measurement results) of the bonding object C and the bonding target object W, a correction value for correcting the degree of parallelization of the bonding object C with respect to the bonding target object W is decided. The inclination of the bonding object C is adjusted via the bonding head 21 in accordance with the correction value, and the inclination of the bonding target object W is adjusted via the stage 1 in accordance with the correction value. Thus, it is possible to adjust the degree of parallelization of the bonding object C held by the bonding head 21 with respect to the bonding target object W held by the chuck 11 of the stage 1. Note that when adjusting the inclination of the bonding target object W via the stage 1, the position of the stage 1 is controlled based on the measurement result of a measurement unit 8.

As described above, according to this embodiment, it is possible to bond the bonding object C and the bonding target object W in a state in which the degree of parallelization of the bonding object C with respect to the bonding target object W is sufficiently ensured. Accordingly, it is possible to suppress the bonding error between the bonding object C and the bonding target object W, thereby further improving the bonding accuracy between the bonding object C and the bonding target object W.

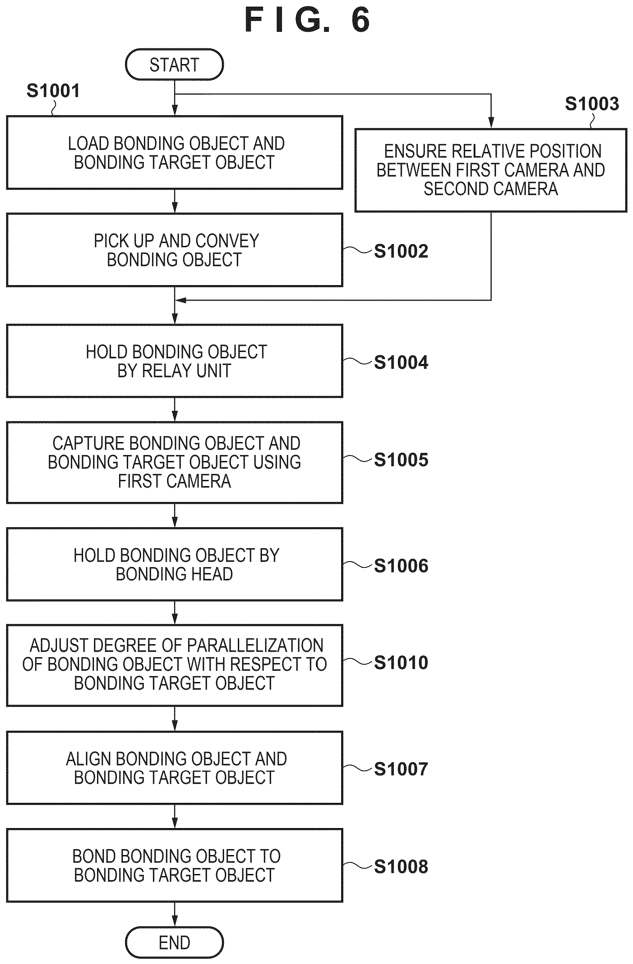

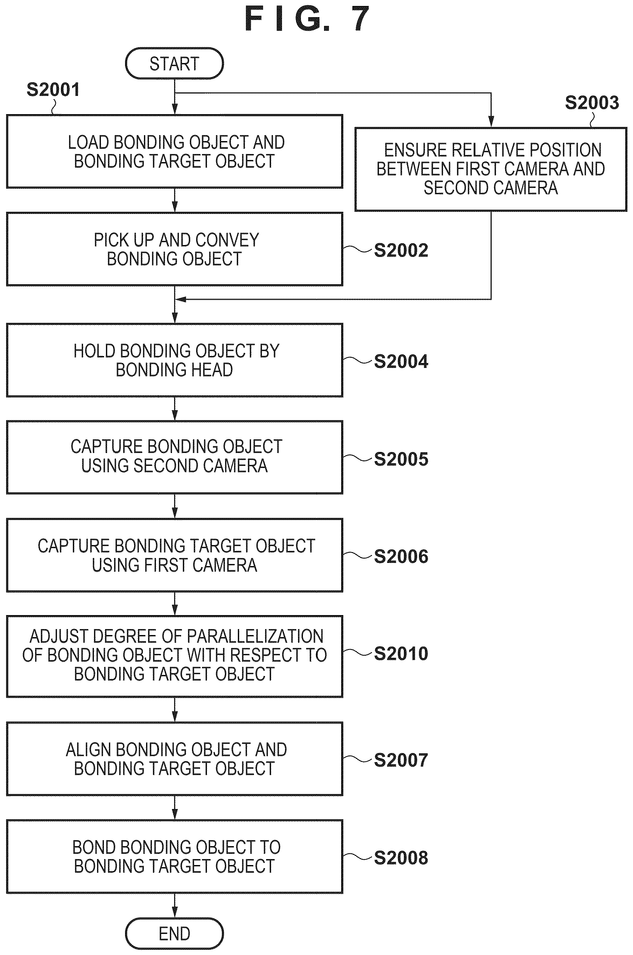

In face-up bonding, as illustrated in Fig. 6, this embodiment is inserted as step S1010 between step S1006 and step S1007 illustrated in Fig. 3. In step S1010, the degree of parallelization of the bonding object C with respect to the bonding target object W is adjusted. On the other hand, in face-down bonding, as illustrated in Fig. 7, this embodiment is inserted as step S2010 between step S2006 and step S2007 illustrated in Fig. 4. In step S2010, the degree of parallelization of the bonding object C with respect to the bonding target object W is adjusted.

### <Fourth Embodiment>

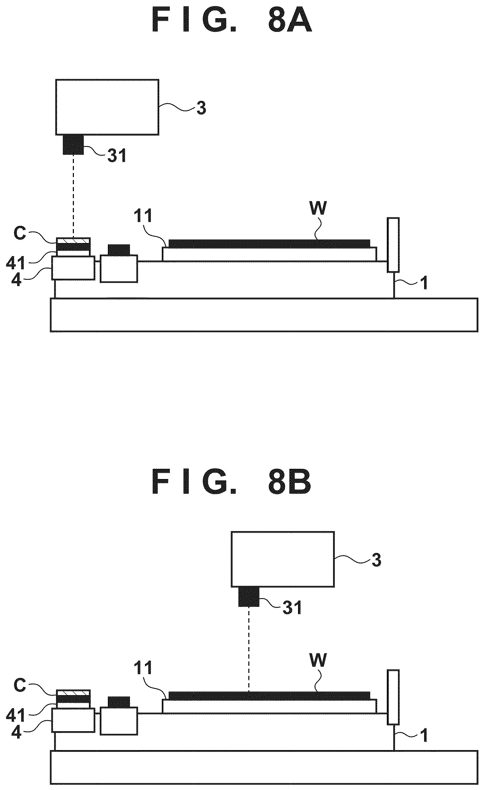

In this embodiment, a technique for improving the bonding accuracy between a bonding object C and a bonding target object W will be described with reference to Figs. 8A and 8B. This technique can be applied to the face-up bonding described in the first embodiment.

In this embodiment, as in the third embodiment, a case will be described in which the degree of parallelization of the bonding object C with respect to the bonding target object W is not sufficiently ensured. In this embodiment as well, the inclination of each of the bonding object C and the bonding target object W is measured, and the inclination of each of the bonding object C and the bonding target object W is adjusted based on the measurement result, thereby adjusting the degree of parallelization of the bonding object C with respect to the bonding target object W. However, in this embodiment, not the inclination of the bonding object C held by a bonding head 21 but the inclination of the bonding object C held by a relay chuck 41 of a relay unit 4 is measured.

More specifically, as illustrated in Fig. 8A, the inclination of the bonding object C is measured from the contrast obtained by a first camera 3 capturing the bonding object C held by the relay chuck 41 of the relay unit 4. In addition, as illustrated in Fig. 8B, the inclination of the bonding target object W is measured from the contrast obtained by the first camera 3 capturing the bonding target object W held by a chuck 11 of a stage 1. Note that the inclination of each of the bonding object C and the bonding target object W may be measured by using an interferometer, a laser displacement meter, or the like and irradiating a plurality of points of each of the bonding object C and the bonding target object W with a laser. Then, based on the inclinations (measurement results) of the bonding object C and the bonding target object W, a correction value for correcting the degree of parallelization of the bonding object C with respect to the bonding target object W is decided. The inclination of the bonding object C and the inclination of the bonding target object W are adjusted via the stage 1 in accordance with the correction value because the relay unit 4 is formed integrally with the stage 1. Note that when adjusting the inclinations of the bonding object C and the bonding target object W via the stage 1, the position of the stage 1 is controlled based on the measurement result of a measurement unit 8. Thus, it is possible to adjust the degree of parallelization of the bonding object C held by the relay chuck 41 of the relay unit 4 with respect to the bonding target object W held by the chuck 11 of the stage 1. Then, the bonding object C held by the relay chuck 41 of the relay unit 4 is passed to the bonding head 21 to hold it. Here, the portion (holding surface) of the bonding head 21 for holding the bonding object C needs to be mechanically adjusted in advance such that the degree of parallelization is sufficiently ensured with respect to the surface of the chuck 11 of the stage 1 for holding the bonding target object W.

As described above, according to this embodiment, it is possible to bond the bonding object C and the bonding target object W in a state in which the degree of parallelization of the bonding object C with respect to the bonding target object W is sufficiently ensured. Accordingly, it is possible to suppress the bonding error between the bonding object C and the bonding target object W, thereby further improving the bonding accuracy between the bonding object C and the bonding target object W.

Similar to the third embodiment, this embodiment can be inserted as step S1010 between step S1006 and step S1007 illustrated in Fig. 3 (see Fig. 6).

### <Fifth Embodiment>

A method of manufacturing an article (a semiconductor IC element, a liquid crystal display element, a MEMS, or the like) using a bonding apparatus BD in the above-described embodiment will be described. The article is manufactured through a preparation step of preparing a bonding object and a bonding target object, a bonding step of bonding the bonding object to the bonding target object using the bonding apparatus BD (bonding method (bonding operation)), and a manufacturing step of manufacturing the article by processing the bonding target object with the bonding object bonded thereto in another known process. The other known process includes probing, dicing, bonding, packaging, and the like. The article manufacturing method according to this embodiment is advantageous in at least one of the performance, quality, productivity, and production cost of the article, as compared to conventional methods.

According to the present disclosure, for example, a technique advantageous in bonding the first object to the second object with high accuracy can be provided.

Various embodiments have been described in detail above but it will be understood that the present disclosure is not limited to these embodiments and encompasses all modifications, variants, alternatives and equivalents falling within the scope of the appended claims.

## Claims

1. A bonding apparatus that bonds a first object and a second object, comprising:
a stage including a relay unit configured to hold the first object, and a holding unit configured to hold the second object;
a head configured to hold the first object;
a driving unit configured to drive at least one of the stage and the head to bond the first object and the second object;
a first camera configured to capture an object on the stage; and
a control unit configured to align the first object held by the head and the second object held by the holding unit based on results of capturing, by the first camera, the first object held by the relay unit and the second object held by the holding unit.

2. The apparatus according to claim 1, further comprising a supporting structure configured to support the first camera and fix a position of the first camera in a first direction and a second direction crossing in a horizontal plane.

3. The apparatus according to claim 1, wherein the relay unit includes a chuck configured to hold the first object by sucking.

4. The apparatus according to claim 1, further comprising a measurement unit including one of an interferometer and an encoder configured to measure a position of the stage,
wherein, in the alignment, the control unit controls movement of the stage based on a measurement result of the measurement unit.

5. The apparatus according to claim 1, further comprising a pickup unit configured to pick up the first object supplied to the apparatus,
wherein
the first object includes a pattern surface formed with a pattern, and
in a case of performing face-up bonding of the first object to the second object with the pattern surface facing upward, the control unit controls the pickup unit such that the first object is held by the relay unit before being held by the head.

6. The apparatus according to claim 5, further comprising a second camera provided on the stage, and configured to capture a first object held by the head,
wherein the control unit
controls the pickup unit such that the first object is held by the head without being held by the relay unit, in a case of performing face-down bonding, of the first object to the second object with the pattern surface facing downward, and
aligns the first object held by the head and the second object held by the holding unit based on a result of the second camera capturing the first object held by the head and a result of the first camera capturing the second object held by the stage.

7. The apparatus according to claim 6, wherein
the stage is capable of moving the second camera to a position in a field of view of the first camera, and
a relative position between the first camera and the second camera is ensured based on a result of the first camera and the second camera capturing each other or either one in a state in which the second camera is located at the position.

8. The apparatus according to claim 6, wherein
the control unit
acquires information about the kind of the first object, and
decides, based on the information, whether to perform face-up bonding of the first object to the second object or perform face-down bonding of the first object to the second object.

9. The apparatus according to claim 6, wherein before performing face-up bonding of the first object to the second object or before performing face-down bonding of the first object to the second object, the control unit adjusts a degree of parallelization of the first object with respect to the second object based on a result of the second camera capturing the first object held by the head and a result of the first camera capturing the second object held by the stage.

10. The apparatus according to claim 9, wherein the control unit adjusts the degree of parallelization by adjusting an inclination of the first object via the head and adjusting an inclination of the second object via the stage.

11. The apparatus according to claim 6, wherein before performing face-up bonding of the first object to the second object, the control unit adjusts a degree of parallelization of the first object with respect to the second object based on results of capturing, by the first camera, the first object held by the relay unit and the second object held by the stage.

12. The apparatus according to claim 1, further comprising a blowout unit configured to blow out clean air from upstream toward downstream of the apparatus.

13. The apparatus according to claim 12, wherein the holding unit is provided upstream of the relay unit with respect to the blowout unit.

14. A bonding method of bonding a first object and a second object, comprising:
capturing the first object held by a relay unit included in a stage, and the second object held by a holding unit included in the stage;
aligning the first object and the second object based on results of the capturing; and
bonding the first object and the second object after the aligning.

15. An article manufacturing method comprising:
preparing a first object and a second object;
bonding the first object and the second object using a boding apparatus defined in claim 1; and
manufacturing an article by processing a boding product obtained by boding the first object and the second object.
